Europäisches Patentamt

European Patent Office

Office européen des brevets

(11) Numéro de publication: **0 047 195**
**A2**

## (12) DEMANDE DE BREVET EUROPEEN

(21) Numéro de dépôt: **81401204.3**

(22) Date de dépôt: **28.07.81**

(51) Int. Cl.³: **H 01 L 23/48**
**H 01 L 23/36**
**//H01L23/30**

(30) Priorité: **06.08.80 FR 8017353**

(43) Date de publication de la demande:
**10.03.82 Bulletin 82/10**

(84) Etats contractants désignés:
**CH DE FR GB IT LI NL**

(71) Demandeur: **SOCIETE POUR L'ETUDE ET LA FABRICATION DE CIRCUITS INTEGRES SPECIAUX E.F.C.I.S.**
**17, avenue des Martyrs**
**F-38100 Grenoble(FR)**

(72) Inventeur: **Vrahides, Michel**
**THOMSON-CSF-SCPI 173, bld Haussmann**
**F-75360 Paris Cedex 08(FR)**

(74) Mandataire: **de Beaumont, Michel**
**"THOMSON-CSF" SCPI 173, Bld Haussmann**
**F-75360 Paris Cedex 08(FR)**

(54) Boitier plastique pour circuits intégrés.

(57) La présente invention concerne le domaine des circuits intégrés.

Un boîtier selon l'invention comprend une plaque de radiateur (10) sur laquelle est fixé un circuit intégré (1). Cette plaque de radiateur a sa deuxième face (12) qui affleure au niveau d'une face principale du boîtier et a une structure étagée. Elle peut être constituée d'un empilement de deux plaquettes thermiquement conductrices (14) et (15).

Application à l'amélioration des boîtiers pour circuits intégrés.

EP 0 047 195 A2

Fig.3

BOÎTIER PLASTIQUE POUR CIRCUITS INTEGRES

La présente invention concerne un boîtier plastique pour circuits intégrés, et plus particulièrement un boîtier qui puisse avoir de très petites dimensions pour un très grand nombre de pattes de connexions (microboîtier).

On entend dans la présente description et dans les revendications ci-après par "boîtier plastique" un boîtier tel que le composant semiconducteur et l'amorce des pattes de connexion sont noyés dans une matière plastique avec addition éventuelle d'une charge minérale.

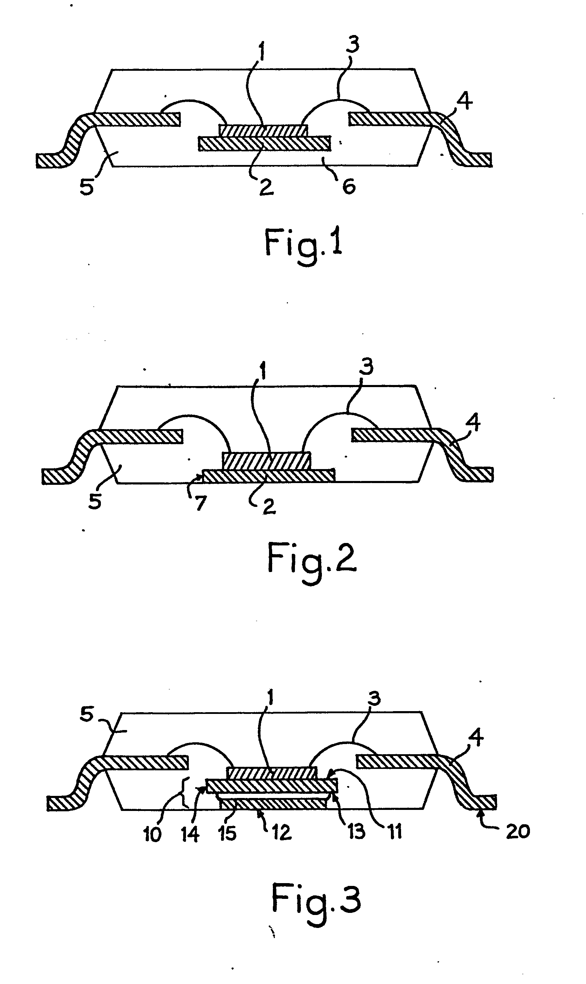

On ne fera pas ici une revue détaillée des divers boîtiers existant pour les circuits intégrés étant donné leur très grand nombre. On rappellera uniquement à titre d'exemple une structure relativement classique, illustrée en figure 1. Une pastille semiconductrice 1 est disposée sur une embase 2 et les différentes bornes du circuit intégré sont reliées par des fils d'or 3 à des pattes de connexion 4. L'ensemble, à l'exception de parties sortantes des pattes de connexion 4, est noyé dans une matière plastique 5.

De façon générale, dans la technique, les pattes de connexion 4 et l'embase 2 font initialement partie d'une grille de montage dont certaines parties sont ensuite découpées pour assurer l'isolement électrique nécessaire entre certaines au moins des pattes de connexion . On concevra que pour minimiser les dimensions totales du boîtier, ce qui est un souci constant dans le domaine des circuits intégrés, chacune des pattes de connexion doit avoir une section aussi faible que possible et notamment une épaisseur aussi faible que possible.

L'une des difficultés qui se pose avec un boîtier plastique du type de celui de la figure 1 résulte des nécessités d'évacuation thermique. Cette évacuation se fait mal à partir de l'embase 2 vers le bas du boîtier à travers la couche plastique 6. On prévoit donc généralement que certaines des pattes de connexions restent solidaires de l'embase 2 et servent à cette évacuation thermique. Ceci impose des exigences contradictoires avec le souhait de minimiser la section des pattes de connexion comme cela a été exposé précédemment.

Pour résoudre ce problème, on a tenté dans l'art antérieur d'adopter des structures du type de celle de la figure 2 dans laquelle l'encapsulation est effectuée de sorte que l'embase 2 affleure au niveau de la face inférieure du boîtier plastique. Néanmoins, le choix de cette solution, s'il permet de résoudre les problèmes d'évacuation thermique, entraîne d'autres difficultés quant à la durée de vie du dispositif. En effet, l'humidité et/ou d'autres contaminants ont tendance à pénétrer à l'interface 7 entre la limite latérale de l'embase 2 et la matière plastique et à se diriger vers le dispositif semiconducteur 1 dont les propriétés se détériorent à la suite de cette contamination. Un autre inconvénient de cette structure est que, si l'embase 2 est très mince, sa fixation ultérieure par soudure sur un radiateur est délicate.

Un objet de la présente invention est de prévoir une nouvelle structure de boîtier plastique qui ne présente pas les inconvénients de l'art antérieur et qui permette de prévoir des pattes de connexion de faible section et donc de petites dimensions tout en résolvant les difficultés liées à d'éventuelles contaminations.

Pour atteindre cet objet ainsi que d'autres, la présente invention prévoit un boîtier plastique pour circuits intégrés dans lequel la pastille semiconductrice repose sur une première face d'une plaque de radiateur dont la deuxième face affleure au niveau de l'une des faces principales du boîtier plastique. Cette plaque de

- 3 -

radiateur comprend une partie périphérique en saillie latéralement, en retrait par rapport à ladite face principale et entièrement noyée dans la matière plastique d'enrobage.

Selon un aspect de la présente invention, la plaque de radiateur a une structure étagée, sa deuxième face ayant une plus petite surface que la première.

Cette plaque de radiateur peut être constituée d'une pièce métallique unique, par exemple une zone en surépaisseur d'une grille de montage comprenant les pattes de connexion ou bien être constituée d'un ensemble de plaquettes solidarisées l'une à l'autre, la première plaquette constituant une partie d'une grille de montage comprenant les pattes de connexion et ayant une surface supérieure à celle de la deuxième plaquette. De préférence, les pattes de connexion émergent des faces latérales du boîtier et sont conformés pour que leurs zones de contact soient situées dans le plan de ladite face principale.

Dans le cas où la plaque de radiateur est constituée de deux plaquettes, la deuxième plaquette de plus faible surface peut être ou bien initialement collée ou brasée sur la grille de connexion, ou bien collée à l'embase du dispositif semiconducteur après encapsulation dans de la résine dans une réserve ou fenêtre ménagée dans la résine lors du moulage.

Selon un autre aspect de la présente invention, la plaque de radiateur a une forme en cuvette à fond plat.

Ces objets, caractéristiques et avantages ainsi que d'autres de la présente invention seront exposés plus en détail dans la description suivante de modes de réalisation particuliers faite en relation avec les figures jointes parmi lesquelles :

Les figures 1 et 2 ont été décrites précédemment et étaient destinées à illustrer l'état de la technique;

La figure 3 représente un boîtier plastique selon la présente invention ;

La figure 4 représente un autre boîtier plastique selon la présente invention.

Comme le représente la figure 3, le dispositif semiconducteur 1 est monté sur un ensemble ou plaque de radiateur 10. Comme dans le cas des modes de réalisation précédents, les divers plots de contacts du circuit intégré 1 sont reliés par des fils conducteurs 3, couramment des fils d'or, à des pattes de connexion 4. L'ensemble du dispositif semiconducteur et des fils de connexion ainsi qu'une partie interne des pattes de connexion est noyé dans une matière plastique telle qu'une résine époxy 5.

La plaque de radiateur 10 comprend une première face 11 sur laquelle est fixée par tous moyens connus la plaquette de circuits intégrés 1. On notera d'ailleurs que cette fixation peut être effectuée par l'intermédiaire d'un moyen thermiquement conducteur mais électriquement isolant. La deuxième face 12 ou face externe de la plaque de radiateur est apparente et est située dans le plan de l'une des faces principales ou face principale inférieure du boîtier plastique. Selon la présente invention, la plaque de radiateur a une structure étagée et comprend au moins un décrochement 13. Cette plaque de radiateur peut être constituée d'une plaque unitaire plus épaisse que les pattes de connexions 4.

De préférence, la plaque de radiateur 10 est composée d'un ensemble d'au moins deux éléments à savoir une première plaquette 14 solidaire du composant semiconducteur 1 et constituant une partie d'une grille de montage avec les pattes de connexions 4, et une deuxième plaquette 15 rapportée sur la première plaquette 14 et fixée à celle-ci par tous moyens connus tels que soudure, brasure, collage... Bien entendu, l'interface entre les plaques 14 et 15 doit nuire aussi peu que possible à une bonne conduction thermique transverse de la plaque de radiateur. La deuxième plaque de radiateur 15 peut être fixée initialement à la partie convenable 14 de la grille de montage avant encapsulation dans la résine 5 ou bien, lors du montage dans la résine, on prévoit une fenêtre dans laquelle est ensuite insérée la plaque 15.

Les avantages de la présente invention ressortent de sa structure. D'une part, étant donné que les pattes de connexion n'ont plus de rôle de conduction thermique à assurer, leur section peut être aussi faible que possible ce qui permet une minimisation des dimensions. D'autre part, étant donné la structure étagée de la plaque de radiateur, et l'existence d'une partie en saillie 13, le contact entre la résine et les parties latérales de la plaque 14 est bon et il est beaucoup plus difficile à l'humidité ou autres impuretés de pénétrer et de cheminer le long de l'interface entre la plaque 14 et la matière plastique ou résine 5 pour venir polluer le composant semiconducteur 1. En effet, d'une part le trajet est allongé, d'autre part la résine effectue un effort de compression sur la partie en saillie 13 qui est "pincée" par la résine alors que dans le mode de réalisation de l'art antérieur de la figure 2 la résine repose seulement sur la face supérieure du radiateur 2 et y adhère mal.

De préférence, les pattes de connexion 4 seront conformées de la façon schématisée dans la figure 3 pour que leurs zones de contacts 20 soient situées dans le plan de la face inférieure du boîtier plastique. Ainsi, quand l'ensemble est fixé sur une surface réceptrice, on peut, au même niveau, souder en une seule opération les pattes de connexions 20 à des bornes de reprise et la face apparente 12 de la plaque de radiateur 10 à un bloc conducteur servant à l'évacuation thermique.

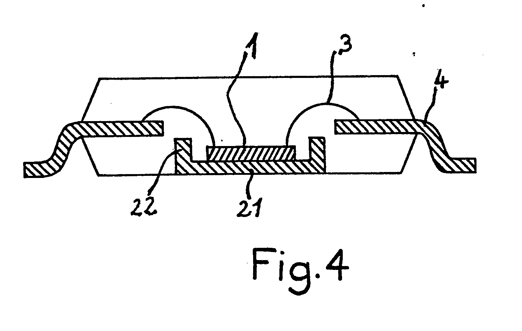

La figure 4 représente un autre mode de réalisation de la présente invention dans lequel la plaque de radiateur prend la forme d'une cuvette à fond plat 21 comportant un rebord 22 tourné vers la masse de la matière plastique d'enrobage. Comme dans le cas précédent, après enrobage, le rebord 22 est pincé par la matière plastique et ce pincement résultant de forces de compression permet une meilleure étanchéité le long de la surface du radiateur vers la plaquette semiconductrice 1.

La présente invention n'est pas limitée aux formes de réalisation qui ont été explicitement décrites. Elle en englobe les diverses variantes et généralisations incluses dans le domaine des revendications ci-jointes.

REVENDICATIONS

1. Boîtier plastique pour circuits intégrés dans lequel la pastille semiconductrice repose sur une première face d'une plaque de radiateur dont la deuxième face affleure au niveau de l'une des faces principales du boîtier plastique, caractérisé en ce que cette plaque de radiateur comprend une partie périphérique en saillie latéralement, en retrait par rapport à ladite face principale et entièrement noyée dans la matière plastique d'enrobage.

2. Boîtier plastique selon la revendication 1 caractérisé en ce que la plaque de radiateur a une structure étagée, sa deuxième face ayant une plus petite surface que la première.

3. Boîtier plastique pour circuits intégrés selon la revendication 2 caractérisé en ce que la plaque de radiateur est constituée d'une pièce métallique unique.

4. Boîtier plastique pour circuits intégrés selon la revendication 3, caractérisé en ce que la plaque de radiateur est constituée à partir d'une zone en surépaisseur d'une grille de montage comprenant les pattes de connexion.

5. Boîtier plastique pour circuits intégrés selon la revendication 2, caractérisé en ce que la plaque de radiateur est constituée d'un ensemble de deux plaquettes solidarisées l'une à l'autre, la première plaquette constituant une partie d'une grille de montage comprenant les pattes de connexions et ayant une surface supérieure à celle de la deuxième plaquette.

6. Boîtier plastique pour circuits intégrés selon la revendication 5, caractérisé en ce que les deux plaquettes sont solidarisées par collage.

7. Boîtier plastique pour circuits intégrés selon la revendication 5, caractérisé en ce que les deux plaquettes sont solidarisées par brasure.

8. Boîtier plastique selon la revendication 1 caractérisé en ce que la plaque de radiateur a une forme en cuvette à fond plat, le rebord de la cuvette étant tourné vers l'intérieur de la matière plastique d'enrobage.

9. Boîtier plastique selon la revendication 8 caractérisé en ce que la cuvette est formée par matricage à partir d'une grille de montage plane comprenant les pattes de connexion.

Fig.1

Fig.2

Fig.3

0047195

Fig.4